# EUROPÄISCHE PATENTSCHRIFT

(11) **EP 0 767 257 B1**
(45) Veröffentlichungstag und Bekanntmachung des Hinweises auf die Patenterteilung: **05.12.2001**
(21) Anmeldenummer: 96114678.4
(22) Anmeldetag: 13.09.1996
(51) Int. Cl.: C25D 5/56, C23C 18/20, C23C 18/14

(54) **Verfahren zum Herstellen integrierter Elektroden in Kunststoff-Formen**
Process for manufacturing integrated electrodes in plastic moulds
Procédé de fabrication d'électrodes intégrées, dans des moules en matière plastique

(30) Priorität: 04.10.1995 DE 19536901
(43) Veröffentlichungstag der Anmeldung: 09.04.1997
(73) Patentinhaber: MICROPARTS GESELLSCHAFT FÜR MIKROSTRUKTURTECHNIK mbH, D-44227 Dortmund (DE)
(72) Erfinder: Reinecke, Holger, Dr. Dipl.-Chem., D-44 287 Dortmund (DE); Nöker, Friedolin Franz, Dipl-Ing., 76133 Karlsruhe (DE)

(56) Entgegenhaltungen:
- WO-A-94/06952
- DE-A- 4 125 863
- PATENT ABSTRACTS OF JAPAN vol. 9, no. 32 (C-265) [1755] , 9.Februar 1985 & JP 59 177385 A (NIPPON DENKI KK), 8.Oktober 1984,

## Beschreibung

Die Erfindung betrifft ein Verfahren zum Herstellen integrierter Elektroden in Kunststoff-Formen, die Hohlräume enthalten.

Die Erfindung bezweckt, das Verfahren zum Herstellen der integrierten Elektroden in strukturierten Kunststoff-Formen wirtschaftlicher zu gestalten und qualitativ hochwertige Elektroden auch in mikrostrukturierten Formen aus nichtleitenden Kunststoffen zu erzeugen.

In DE - 35 37 483 ist ein Verfahren zum Herstellen einer Vielzahl plattenförmiger Mikrostrukturkörper aus Metall beschrieben, bei dem durch Abformen eines mikrostrukturierten Werkzeugs mit einer elektrisch isolierenden Abformmasse Negativformen der Mikrostrukturen erzeugt werden, die galvanisch mit einem Metall aufgefüllt werden. Anschließend werden die Negativformen entfernt. Dabei wird ein elektrisch leitendes Material wieder lösbar auf die Stirnflächen der Mikrostrukturen des Werkzeugs aufgebracht, das beim Abformen auf die diesen Stirnflächen gegenüberliegenden Bereichen der Abformmasse übertragen wird.

Bei einer Variante dieses Verfahrens kann die elektrisch isolierende Abformmasse, die die Zwischenräume der Mikrostruktur des Werkzeugs ausfüllt, mit einer Schicht aus elektrisch leitender Abformmasse verbunden werden, wobei die elektrisch leitende Abformmasse die Stirnflächen der Mikrostrukturen des Werkzeugs berührt und die elektrisch leitende Abformmasse das ganze Werkzeug überdeckt.

In DE - 40 10 669 wird ein Verfahren zur Herstellung galvanisch abformbarer Negativformen mikrostrukturierter plattenförmiger Körper beschrieben, deren Strukturgrund eine zusammenhängende Fläche bildet und mit einer Schicht elektrisch leitenden Materials überzogen ist. Zum Herstellen der Negativform wird ein Formeinsatz in eine Schicht eines Thermoplasten, auf der ein Film eines elektrisch leitenden Materials aufgebracht ist, durch den Film hindurch in die erwärmte weiche Thermoplast-Schicht eingedrückt. Nach dem Abkühlen des Thermoplasten wird die Negativform von dem Formeinsatz getrennt.

Beim Prägevorgang wird der zusammenhängende Film des elektrisch leitenden Materials an der Stirnfläche des Formeinsatzes entsprechend der Geometrie der Mikrostruktur zerteilt. Die die Stirnfläche des Formeinsatzes berührenden Bereiche bleiben dort haften, die anderen Bereiche des Films werden beim Prägen von dem in die Hohlräume fließendem Kunststoff bis zum Boden des Formeinsatzes geschoben. Teile des Films können an den Seitenwänden als Flitter verbleiben. Die Flitter werden gegebenenfalls durch eine aufwendige Reinigung aus der Negativform beseitigt, bevor Metall in der Negativform abgeschieden wird. Nach dem Entformen der Negativform bilden die Stirnflächenbereiche des Formeinsatzes den Strukturgrund der Negativform, der mit einem zusammenhängenden leitfähigen Film überzogen ist, der vom Rand her kontaktierbar ist. Die Metallflitter an den Wänden und der Stirnfläche der Negativform rühren her von dem beim Prägen nicht ideal zerteilten leitfähigen Film; die Flitter haben teilweise Kontakt zur leitfähigen Schicht auf dem Strukturgrund der Negativform und führen zu partiell leitfähigen Seitenwänden. Hierdurch wird das gerichtete Abscheiden von Metall in der Negativform gestört; es entstehen Fehlstellen, Überhöhungen und Kavernen im abgeformten metallenen Mikrostrukturkörper.

Der Film besteht bevorzugt aus Gold, Kupfer, Silber und deren Legierungen oder aus Kohlenstoff. Ein derartiger Film auf der zusammenhängenden Fläche der Strukturgrundes ist als Elektrode für das galvanische Abscheiden anderer Metalle, z.B. Kupfer oder Nickel geeignet. Für das stromlose Abscheiden solcher Metalle ist er wenig geeignet.

In JP - A - 59 177 358 sind eine Vorrichtung und ein Verfahren angegeben, mit dem Metall aus einer Lösung mittels Laserlicht abgeschieden wird. Die verwendeten Lösungen enthalten ein Organometall, wie Chrombenzol oder Molybdänbenzol.

Die Lösung wird an vorbestimmten Stellen punktuell auf die Oberseite eines Substrates aufgetragen und durch das Substrat hindurch mittels Laserlicht bestrahlt, wobei das Metall an der belichteten Stelle abgeschieden wird.

Die Vorrichtung besteht aus einer Präzisionshalterung für das Substrat, die mittels Schrittmotoren verschoben wird, einem Mechanismus zum Auftropfen der Lösung, einer Quelle sowie einer Fokussiereinrichtung für das Laserlicht, einer Vorrichtung zum Steuern des Auftropfmechanismus und der Laservorrichtung, mittels welcher der Auftropfmechanismus und die Laservorrichtung synchronisiert werden und die Bewegung der Halterung gesteuert wird, einem System zum Inertisieren des Raumes zwischen dem Austritt der Lösung aus dem Vorratsgefäß, der vorbestimmten Stelle auf dem Substrat und dem Fallweg des Lösungstropfens.

Der Tropfen besteht aus einer winzigen Menge der Lösung. Die Auftropfvorrichtung kann ähnlich wie ein Tintenstrahldrucker arbeiten. Das Metall wird mittels Laserlicht aus der Lösung abgeschieden, sobald sich der Tropfen auf dem Substrat befindet.

Das Laserlicht wirkt kurzzeitig und ist intensiv, damit viele Tropfen an verschiedenen Stellen nacheinander bei vertretbarem Zeitbedarf belichtet werden können, um an vielen punktförmig verteilten Stellen nacheinander Metall abzuscheiden. Das Verfahren setzt ein Substrat voraus, das durch das kurzzeitig einwirkende intensive Laserlicht nicht beeinträchtigt wird, wie Halbleiter, Glas oder Kristall.

Damit stellt sich die Aufgabe, ein Verfahren zum Herstellen integrierter Elektroden in strukturierten und Hohlräume enthaltenden Kunststoff-Formen aus nichtleitenden Kunststoffen zu finden, das sich wirtschaftlicher durchführen läßt als die Verfahren nach dem Stand der Technik.

Diese Aufgabe wird erfindungsgemäß gelöst durch ein Verfahren mit den Merkmalen des Anspruchs 1.

Die strukturierte Kunststoff-Form wird durch Spritzgießen, Reaktionsgießen, Warmformen oder ein anderes Verfahren mittels eines strukturierten Werkzeugs hergestellt. Nach dem Erstarren des Kunststoffs im Werkzeug wird die Kunststoff-Form vom Werkzeug getrennt. Die zur Struktur des Werkzeugs komplementäre Struktur befindet sich auf einer Trägerplatte mit definierter Dicke.

zum Herstellen der strukturierten Kunststoff-Form auf einer Trägerplatte wird entweder ein einheitlicher Kunststoff verwendet, oder die strukturierte Kunststoff-Form ist zweischichtig; die erste Schicht ist die strukturierte Kunststoff-Schicht und besteht aus einem anderen Kunststoff als die zweite Schicht. Im letzten Fall kann der Kunststoff für die zweite Schicht unter anderem bezüglich seiner Durchlässigkeit für elektromagnetische Strahlung auf die Wellenlänge der zum Bestrahlen verwendeten elektromagnetischen Strahlung abgestimmt werden. Die Trägerplatte kann auf ihrer Rückseite auf eine für das Bestrahlen geeignete Dicke und Oberflächenbeschaffenheit abgearbeitet werden.

Als Thermoplaste sind beispielsweise Polymethylmethacrylat, Polyoxymethylen, Polystyrol, Acrylnitrilhutadienstyrol und Polyamid geeignet.

Unter "Lösung einer Metallverbindung" wird eine physikalische Lösung, eine Suspension oder eine kolloidale Lösung verstanden. Die Metallverbindung ist eine Verbindung im engeren Sinne, ein Metallkomplex oder ein Metall selbst. Die gelöste Metallverbindung kann ein anorganisches Salz (z.B. Silbernitrat, Goldsulfit), eine organische Metallverbindung (z.B. Palladiumacetat, Silbertosylat) oder ein Metallkomplex (z.B. ein Aminokomplex wie Silberdiaminkomplex oder Kupfertetraminkomplex) sein. Die Lösung kann verschiedene Metalle nebeneinander enthalten.

Die in die Hohlräume der Struktur der Kunststoff-Form gefüllte Lösung der Metallverbindung wird mit Laserlicht, ultraviolettem Licht oder Röntgenstrahlung von der Rückseite der Trägerplatte durch die Trägerplatte hindurch bestrahlt. Die Strahlung kann entweder auf die gesamte Rückseite der Trägerplatte mit derselben Intensität einfallen, oder mit bereichsweise unterschiedlicher Intensität, oder durch eine Maske hindurch, die auf der Rückseite der Trägerplatte lose aufliegt oder mit der Trägerplatte verbunden ist, z.B. durch eine aufgesputterte Maske.

Nach dem Bestrahlen wird die Lösung der Metallverbindung aus den Hohlräumen der Struktur der Kunststoff-Form beseitigt, z.B. durch Ausspülen.

Beim Bestrahlen der Lösung der Metallverbindung durch die Trägerplatte hindurch wird die Metallverbindung nur in unmittelbarer Nähe des Strukturgrundes chemisch umgewandelt, wobei sich das Metall auf dem Strukturgrund als Schicht ablagert und die Elektroden bildet. Diese Schicht verhindert wegen ihrer geringen Durchlässigkeit gegen die verwendete elektromagnetische Strahlung die weitere chemische Umwandlung der gelösten Metallverbindung und das Abscheiden von Metall an den Seitenwänden der Struktur, auch bei längerdauernder Bestrahlung.

Die Wellenlänge der benutzten elektromagnetischen Strahlung und die Dauer der Bestrahlung sind auf den für die Trägerplatte verwendeten Kunststoff, auf die Dicke der Trägerplatte und auf die Art der Metallverbindung abgestimmt. Falls erforderlich, kann die Elektrode umgefällt, beschichtet oder geätzt werden und an spezielle Erfordernisse der nachfolgenden Verfahrensstufen angepaßt werden.

Der Strukturgrund der strukturierten Kunststoff-Form kann zusammenhängend oder nicht zusammenhängend sein. Im ersten Fall ist die Elektrode zentral kontaktierbar. Im zweiten Fall sind die Elektroden nicht zentral kontaktierbar.

Eine Struktur mit zusammenhängender Elektrode ist sowohl für stromloses als auch für galvanisches oder elektrophoretisches Abscheiden eines Werkstoffs - ausgehend von der leitenden Elektrode - geeignet. Eine Struktur mit nicht zusammenhängenden Elektroden ist fast nur für ein stromloses Abscheiden von Werkstoff - ausgehend von den Elektroden - geeignet. Zum stromlosen Abscheiden von Metall werden zur Bildung der Elektroden bevorzugt Palladium-Lösungen eingesetzt. Auf einer Palladium-Elektrode lassen sich Nickel, Kupfer, Gold und andere Metalle sehr gut stromlos abscheiden.

Die Elektroden auf dem Strukturgrund der Kunststoff-Form können einschichtig oder mehrschichtig sein. Für zweischichtige Elektroden geht man von einer strukturierten Kunststoff-Form mit integrierten Elektroden aus, die nach dem Verfahren nach Anspruch 1 hergestellt wurden. In die Hohlräume der strukturierte Kunststoff-Form mit integrierten Elektroden wird die Lösung oder Suspension eines Metalls, einer Metallverbindung, eines Kunststoffs, eines Sinterwerkstoffes oder eines keramischen Werkstoffes gefüllt. Auf den integrierten Elektroden scheidet sich als zweite Schicht die Schicht des gelösten oder suspendierten Werkstoffes ab. Der Werkstoff kann stromlos oder strombehaftet abgeschieden werden. Sobald diese Schicht die gewünschte Dicke erreicht hat, wird die Lösung oder Suspension des Werkstoffs aus den Hohlräumen der Struktur der Kunststoff-Form beseitigt. Dieser Vorgang wird zum Herstellen mehrschichtiger Elektroden aus mehreren Werkstoffen mehrfach nacheinander durchgeführt.

Das erfindungsgemäße Verfahren wird bevorzugt auf strukturierte Kunststoff-Formen aus nichtleitenden Kunststoffen angewendet, die mikrostrukturiert sind.

Die strukturierten Kunststoff-Formen aus nichtleitenden Kunststoffen mit integrierten Elektroden auf dem Strukturgrund lassen sich für verschiedene Zwecke verwenden, z.B. für
- das stromlose oder strombehaftete Abscheiden von Metall zum Herstellen eines strukturierten Körpers aus Metall,
- das elektrophoretische Abscheiden von Keramik, Metallen, Metall-Legierungen, Kunststoffen oder Sinterwerkstoffen zum Herstellen eines strukturierten Körpers aus einem der abgeschiedenen Werkstoffe,
- analytische Systeme, bevorzugt mikroanalytische Systeme.

In den ersten beiden Fällen beginnt das Abscheiden von Werkstoff auf den integrierten Elektroden. Die Struktur des aus dem abgeschiedenen Werkstoff gebildeten Körpers ist komplementär zur Struktur der Kunststoff-Form.

Der durch das Abscheiden von Werkstoff in der strukturierten Kunststoff-Form mit integrierten Elektroden gebildete Körper kann aus einem einzigen Werkstoff bestehen, oder er kann aus mehreren Werkstoffen bestehen, die schichtförmig übereinander liegen.

Falls die strukturierte Kunststoff-Form mit integrierten Elektroden zum Abscheiden von Werkstoff benutzt worden ist, wird die Kunststoff-Form von dem entstandenen Strukturkörper mechanisch getrennt, oder die Kunststoff-Form wird (als verlorene Form) aus dem Strukturkörper herausgelöst. Die Elektroden befinden sich auf den Stirnflächen des Strukturkörpers und werden gegebenenfalls von den Stirnflächen beseitigt, z.B. durch selektives Ätzen.

Das erfindungsgemäße Verfahren hat folgende Vorteile:
- Die Elektroden befinden sich nur auf dem Strukturgrund der Kunststoff-Form. An den Seitenwänden der Struktur haften keine Metallflitter.
- Das stromlose oder das galvanische Abscheiden von Werkstoff in der Struktur der Kunststoff-Form beginnt nur an den Elektroden. Der Abscheidevorgang verläuft störungsfrei, es entstehen keine Fehlstellen, Überhöhungen oder Kavernen im beim Abscheiden entstandenen Strukturkörper.
- Für die Elektroden können bevorzugt solche Metalle verwendet werden, die für das stromlose Abscheiden von Werkstoff in der Kunststoff-Form besonders geeignet sind.
- Der für das Herstellen der strukturierten Kunststoff-Form verwendete Kunststoffkörper (Präge-Rohling) wird ohne jede Vorbehandlung eingesetzt.
- Der Kunststoff für die Trägerplatte kann auf den Bestrahlungsprozeß abgestimmt werden, der Kunststoff für die strukturierte Schicht auf den Abformprozeß.
- Die Elektroden auf dem Strukturgrund werden getrennt von der Herstellung der Kunststoff-Form gebildet.
- Nach dem Beseitigen der Lösung der Metallverbindung aus der strukturierten Kunststoff-Form kann diese Form unmittelbar verwendet werden.
- Die Kunststoff-Form kann von dem beim Abscheiden von Werkstoff entstandenen Strukturkörper mechanisch getrennt und gegebenenfalls wiederholt verwendet werden.
- Die Kunststoff-Formen mit integrierten Elektroden sind für stromloses, galvanisches oder elektrophoretisches Abscheiden von Werkstoff in der Kunststoff-Form sowie für analytische Verfahren geeignet.

Das erfindungsgemäße Verfahren wird an Hand der Figuren weiter erläutert.

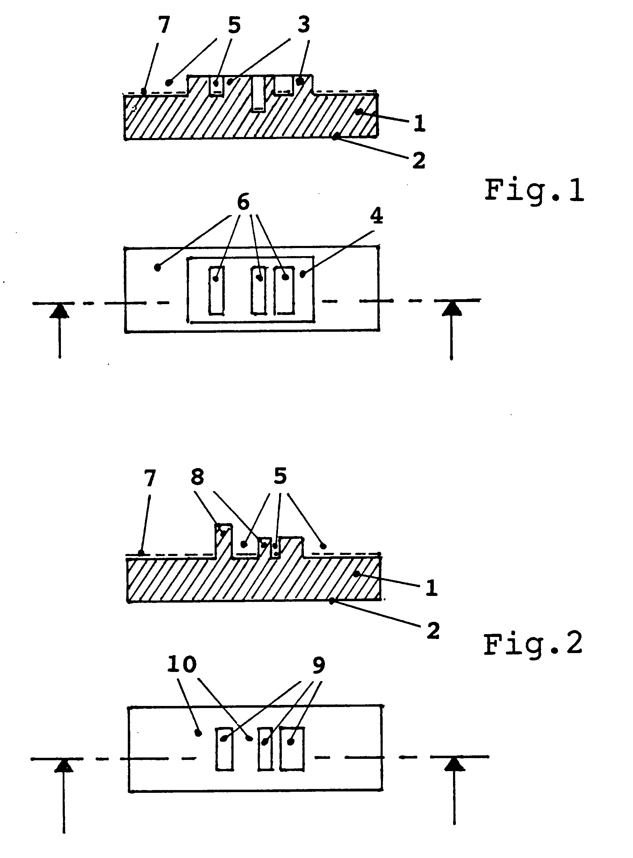

Figur 1 zeigt eine strukturierte Kunststoff-Form mit Gitterstruktur in Aufsicht und im Längsschnitt. Aus der Trägerplatte (1) mit glatter Rückseite (2) tritt das Gitter (3) hervor, das eine zusammenhängende Fläche (4) bildet. Innerhalb und außerhalb dieser Fläche liegen inselförmige Hohlräume (5). Der Strukturgrund hat eine Inselstruktur und bildet eine nicht zusammenhängende Fläche (6). Auf dem Strukturgrund befinden sich die integrierten Elektroden (7).

Figur 2 zeigt eine strukturierte Kunststoff-Form mit Inselstruktur in Aufsicht und im Längsschnitt. Aus der Trägerplatte (1) mit glatter Rückseite (2) treten die Inseln (8) hervor, die eine nicht zusammenhängende Fläche (9) bilden. Zwischen den Inseln liegen die Hohlräume (5). Der Strukturgrund hat eine Gitterstruktur und bildet eine zusammenhängende Fläche (10). Auf dem Strukturgrund befindet sich die Elektrode (7).

### Beispiel 1:Herstellen von mikrostrukturierten Filterscheiben

Die herzustellenden Filterscheiben aus Nickel haben sechseckige Waben mit folgenden Abmessungen:

| | |
|---|---|
| Außendurchmesser der Scheiben | 3 mm |
| Innenkreisdurchmesser der Waben | 80 µm |
| Breite der Stege | 8 µm |
| Höhe der Stege | 270 bis 280 µm. |

Die Kunststoff-Form hat die komplementäre Struktur, jedoch eine Strukturhöhe von 300 *µ*m.

Das mikrostrukturierte Werkzeug (aus Nickel), dessen Struktur mit der Struktur der Filterscheiben übereinstimmt, enthält auf einer Fläche von 60 mm x 22 mm Strukturen für insgesamt 105 Filterscheiben. Mit diesem Werkzeug wird eine Kunststoff-Form aus Polymethylmethacrylat hergestellt, deren Mikrostruktur in der strukturierten Schicht zur Mikrostruktur des Werkzeugs komplementär ist. Die 300 *µ*m hohe Mikrostruktur befindet sich auf einer 1,5 mm dicken Trägerplatte aus Polymethylmethacrylat.

Die Hohlräume der mikrostrukturierten Kunststoff-Form hängen innerhalb jeder Filterscheibe zusammen. Zwischen den Hohlräumen zweier Filterscheiben besteht jedoch keine Verbindung, der Strukturgrund aller 105 Filterscheiben ist also nicht zusammenhängend.

Die Hohlräume der mikrostrukturierten Kunststoff-Form werden zunächst mit einer wässrigen Lösung, die 0,3 mol Silber-acetat pro Liter enthält, blasenfrei gefüllt. Die Kunststoff-Form wird mit einer Quecksilberdampflampe (100 W elektrische Leistung), die sich in einem Abstand von 1,5 cm von der Kunststoff-Form befindet, von der Rückseite der Trägerplatte durch die Trägerplatte hindurch 2 Minuten lang bestrahlt. Dabei bilden sich auf dem Strukturgrund der Kunststoff-Form die Elektroden als dichte Silberschichten. Die Silberacetat-Lösung wird aus der Kunststoff-Form abgesaugt, und die Kunststoff-Form wird mit Reinstwasser gespült.

Die Hohlräume der mikrostrukturierten Kunststoff-Form werden mit einer wässrigen Lösung, die 2,0 mmol Palladiumchlorid pro Liter enthält, blasenfrei gefüllt. Nach 15 Minuten bei Zimmertemperatur sind die Silberschichten auf dem Strukturgrund gegen Palladiumschichten ausgetauscht. Die Palladiumchlorid-Lösung wird aus der Kunststoff-Form abgesaugt, und die Kunststoff-Form wird mit Reinstwasser gespült. Die nicht zusammenhängenden Palladiumschichten bilden die Elektroden auf dem Strukturgrund der Kunststoff-Form.

Zum stromlosen Füllen der Hohlräume der Kunststoff-Form mit Nickel wird die Kunststoff-Form in eine Lösung getaucht, die 50 g Nickelchlorid pro Liter enthält. Nach 21 Stunden bei etwa 60 °C sind die Hohlräume der Kunststoff-Form in einer Höhe von 276 *µ*m mit Nickel gefüllt.

Die mit Nickel gefüllte Kunststoff-Form wird aus dem Nickelbad entnommen und mit Reinstwasser gespült. Anschließend wird die Kunststoff-Form in heißem Ethylacetat gelöst, wobei die Filterscheiben von der Kunststoff-Form getrennt werden und bereits vereinzelt vorliegen. Die nachträgliche Vereinzelung der Filterscheiben durch mechanisches Nacharbeiten der Außenkonturen ist also weder erforderlich noch wegen der engen Maßtoleranzen und der geforderten geringen Rauheit zulässig.

### Beispiel 2: Herstellen einer beheizbaren analytischen Komponente

Eine analytische Komponente besteht aus einem Y-förmig angeordneten Flüssigkeitsteiler mit Elektroden auf dem eine zusammenhängende Fläche bildenden Strukturgrund. Mittels der elektrisch beheizten Elektroden wird eine hindurchfließende Flüssigkeit erwärmt.

Eine Kunststoff-Form aus Polysulfon (10 mm breit, 20 mm lang, 3 mm dick) wird im Spritzgußverfahren erzeugt. Der Y-förmige Kanal ist 1 mm breit und 1 mm tief. In die Struktur wird eine Lösung eingefüllt, die 0,1 mol Goldsulfit pro Liter enthält. Die Kunststoff-Form wird von der Rückseite der Struktur mit einer UV-Lampe (1 kW elektrische Leistung), die sich in einem Abstand von 40 cm von der Kunststoff-Form befindet, bestrahlt. Zwischen UV-Lampe und Kunststoff-Form ist eine Sammellinse aus Quarz angebracht. Nach einer Bestrahlungszeit von 45 Minuten hat sich auf dem Strukturgrund der Kunststoff-Form eine dichte Goldschicht gebildet. Die nicht umgesetzte Goldsulfit-Lösung wird aus der Kunststoff-Form entfernt, und die Form wird mit Reinstwasser gespült.

Anschließend wird die Kunststoff-Form in eine Lösung gehängt, aus der eine Kupfer-Nickel-Legierung elektrolytisch abgeschieden wird. Bei einer Stromdichte von 1 A / dm² wird in 10 Minuten bei 65 °C eine Kupfer-Nickel-Legierung in einer 1,2 *µ*m dicken Schicht auf dem Strukturgrund abgeschieden. Die Kunststoff-Form wird aus der Lösung entnommen, gespült, getrocknet und mit einem Kunststoff-Deckel verklebt.

Nach dem Anbringen von Zuleitungen an den Elektroden kann über eine Widerstandsheizung eine in dem Y-förmigen Flüssigkeitsteiler befindliche Flüssigkeit erhitzt werden.

Diese Komponente wird in einem analytischen System zum Erhitzen einer Flüssigkeit verwendet, in der eine chemische Reaktion photometrisch untersucht wird.

## Patentansprüche

1. Verfahren zum Herstellen integrierter Elektroden in strukturierten und Hohlräume enthaltenden Kunststoff-Formen aus nichtleitenden Kunststoffen, **gekennzeichnet durch**
- Herstellen der strukturierten Kunststoff-Form auf einer Trägerplatte, die für elektromagnetische Strahlung durchlässig ist,
- Füllen der Hohlräume der Struktur der Kunststoff-Form mit einer wäßrigen Lösung einer Metallverbindung die ein salz oder ein Metallkomplex ist
- Bestrahlen der Lösung der Metallverbindung mit elektromagnetischer Strahlung von der Rückseite der Trägerplatte **durch** die Trägerplatte hindurch, wobei die integrierten Elektroden nur auf dem Strukturgrund **durch** Abscheiden von Metall aus der Metallverbindung gebildet werden, und
- Beseitigen der Lösung der Metallverbindung aus den Hohlräumen der Struktur der strukturierten Kunststoff-Form.

2. Verfahren nach Anspruch 1, **gekennzeichnet durch**
- Herstellen der strukturierten und Hohlräume enthaltenden Kunststoff-Form auf einer Trägerplatte aus einheitlichem Kunststoff.

3. Verfahren nach Anspruch 1, **gekennzeichnet durch**
- Herstellen der strukturierten und Hohlräume enthaltenden Kunststoff-Form auf einer Trägerplatte, wobei die strukturierte Kunststoff-Form zweischichtig ist und die erste Schicht die strukturierte Kunststoff-Schicht ist, die aus einem anderen Kunststoff besteht als die zweite Schicht.

4. Verfahren nach den Ansprüchen 1 bis 3, **gekennzeichnet durch**
- Herstellen der strukturierten Kunststoff-Form auf einer Trägerplatte, wobei die Trägerplatte an ihrer Rückseite auf eine für das Bestrahlen geeignete Dicke und Oberflächenbeschaffenheit abgearbeitet wird.

5. Verfahren nach den Ansprüchen 1 bis 4, **gekennzeichnet durch**
- Bestrahlen der Lösung der Metallverbindung mit Laserlicht, ultraviolettem Licht oder Röntgenstrahlung.

6. Verfahren nach den Ansprüchen 1 bis 5, **gekennzeichnet durch**
- partielles Bestrahlen der Lösung der Metallverbindung, gegebenenfalls bereichsweise mit unterschiedlicher Intensität.

7. Verfahren nach den Ansprüchen 1 bis 6, **gekennzeichnet durch**
- Bestrahlen der Lösung der Metallverbindung über eine auf der Rückseite der Trägerplatte angebrachte für die verwendete elektromagnetische Strahlung bereichsweise undurchlässige Maske.

8. Verfahren zum Herstellen mehrschichtiger Elektroden in strukturierten Kunststoff-Formen aus nichtleitenden Kunststoffen, die mit einer nach Anspruch 1 hergestellten integrierten Elektrode versehen sind,**gekennzeichnet durch**
- Füllen der Hohlräume der Struktur der Kunststoff-Form mit der Lösung oder Suspension eines Metalls oder einer Metallverbindung oder eines Sinterwerkstoffes oder eines keramischen Werkstoffes,
- Abscheiden einer Schicht des gelösten oder suspendierten Werkstoffes auf den integrierten Elektroden,
- Beseitigen der Lösung oder Suspension des Werkstoffes aus den Hohlräumen der Struktur der Kunststoff-Form.

9. Verfahren nach Anspruch 8, **gekennzeichnet durch**
- nacheinander mehrmaliges Füllen der Hohlräume der Struktur der Kunststoff-Form mit der Lösung oder Suspension unterschiedlicher Werkstoffe,
- nacheinander Abscheiden mehrerer Schichten aus den verschiedenen Werkstoffen übereinander auf den integrierten Elektroden.

10. Verfahren nach den Ansprüchen 1 bis 9, angewendet auf strukturierte Kunststoff-Formen aus nichtleitenden Kunststoffen, die eine Mikrostruktur aufweisen.

## Claims

1. A process for the production of an integrated electrode in a structured, cavity-containing plastic mould made from a non-conductive plastic, **characterized by**
- production of the structured plastic mould on a support plate which allows electromagnetic radiation to pass through,
- filling of the cavities in the structure of the plastic mould with an aqueous solution of a metal compound which is a salt or a metal complex,
- irradiation of the solution of the metal compound with electromagnetic radiation from the back of the support plate through the support plate, the integrated electrode being formed only on the structure base by deposition of metal from the metal compound, and
- removal of the solution of the metal compound from the cavities of the structure of the structured plastic mould.

2. A process according to claim 1, **characterized by**
- production of the structured, cavity-containing plastic mould on a support plate from a uniform plastic.

3. A process according to claim 1, **characterized by**
- production of the structured, cavity-containing plastic mould on a support plate, the structured plastic mould having two layers and the first layer being the structured plastic layer, which consists of a different plastic from the second layer.

4. A process according to any of claims 1 to 3, **characterized by**
- production of the structured plastic mould on a support plate, the support plate being worked down on its back face to a thickness and surface nature which is suitable for the irradiation.

5. A process according to any of claims 1 to 4, **characterized by**
- irradiation of the solution of the metal compound with laser light, ultra-violet light or X-rays.

6. A process according to any of claims 1 to 5, **characterized by**
- partial irradiation of the solution of the metal compound, optionally with different intensity from area to area.

7. A process according to any of claims 1 to 6, **characterized by**
- irradiation of the solution of the metal compound through a mask which is mounted on the back face of the support plate and is opaque in partial areas to the electromagnetic radiation used.

8. A process for the production of a multilayered electrode in a structured plastic mould made from a non-conductive plastic which is provided with an integrated electrode produced according to claim 1, **characterized by**
- filling of the cavities in the structure of the plastic mould with the solution or suspension of a metal or of a metal compound or of a sintered material or of a ceramic material
- deposition of a layer of the dissolved or suspended material on the integrated electrodes, and
- removal of the solution or suspension of the material from the cavities of the structure of the plastic mould.

9. A process according to claim 8, **characterized by**
- repeated filling of the cavities in the structure of the plastic mould with the solution or suspension of different materials one after the other,
- deposition of several layers of different materials one above the other on the integrated electrodes.

10. A process according to any of claims 1 to 9 applied to structured plastic moulds made from non-conductive plastics said moulds having a microstructure.

## Revendications

1. Procédé de fabrication d'électrodes intégrées dans des moules en matière plastique structurée et comportant des cavités en des matières plastiques non conductrices,
**caractérisé en ce qu'**
- on fabrique un moule en matière plastique structurée sur une plaque de support perméable au rayonnement électromagnétique,
- on remplit les cavités de la structure du moule en matière plastique avec une solution aqueuse d'un composé métallique qui est un sel ou un complexe métallique,
- on expose la solution du composé métallique au rayonnement électromagnétique par la face arrière du plateau de support à travers celui-ci et on forme les électrodes intégrées seulement sur le fond de la structure par dépôt du métal du composé métallique et,
- on élimine la solution du composé métallique des cavités de la structure du moule en matière plastique structurée.

2. Procédé selon la revendication 1,
**caractérisé en ce qu'**
- on réalise un moule en matière plastique structurée et comportant des cavités sur une plaque de support en une matière plastique uniforme.

3. Procédé selon la revendication 1,
**caractérisé en ce qu'**
- on fabrique le moule en matière plastique structurée et comportant des cavités sur un plateau de support, le moule en matière plastique structurée étant à deux couches, la première couche étant la couche de matière plastique structurée qui est dans une autre matière plastique que la seconde couche.

4. Procédé selon l'une quelconque des revendications 1 à 3,
**caractérisé en ce qu'**
- on réalise le moule en matière plastique structurée sur une plaque de support dont le côté arrière a les caractéristiques de surface et une épaisseur convenant pour l'exposition par rayonnement.

5. Procédé selon l'une quelconque des revendications 1 à 4,
**caractérisé en ce qu'**
- on expose la solution du composé métallique avec la lumière laser, la lumière ultraviolette ou un rayonnement x.

6. Procédé selon l'une quelconque des revendications 1 à 5,
**caractérisé en ce qu'**
- on expose partiellement la solution du composé métallique le cas échéant par zone avec une intensité différente.

7. Procédé selon l'une quelconque des revendications 1 à 6,
**caractérisé en ce qu'**
- on expose la solution du composé métallique par l'intermédiaire d'un masque appliqué sur le côté arrière du plateau de support et qui est opaque au rayonnement électromagnétique utilisé.

8. Procédé de fabrication d'électrodes à plusieurs couches dans des moules en matière plastique structurée en matière plastique non conductrice, avec des électrodes intégrées fabriquées selon le procédé de la revendication 1,
**caractérisé en ce qu'**
- on remplit les cavités de la structure du moule en matière plastique avec la solution ou la suspension d'un métal ou d'un composé métallique ou d'une matière frittée ou d'une céramique,
- on dépose une couche de la matière dissoute ou en suspension sur les électrodes intégrées,
- on élimine la solution ou la suspension de la matière des cavités de la structure du moule en matière plastique.

9. Procédé selon la revendication 8,
**caractérisé en ce qu'**
- on remplit les cavités de la structure du moule en matière plastique avec la solution ou la suspension des différentes matières, successivement,
- on dépose, l'un sur l'autre, plusieures couches en différentes matières sur les electrodes intégrées.

10. Procédé selon l'une quelconque des revendications 1 à 9 appliqué à des moules en matière plastique structurée, en matière plastique non conductrice qui ont une microstructure.
